# EUROPÄISCHE PATENTANMELDUNG

(11) **EP 1 170 787 A1**
(43) Veröffentlichungstag der Anmeldung: **09.01.2002**
(21) Anmeldenummer: 00810577.7
(22) Anmeldetag: 03.07.2000
(51) Int. Cl.: H01L 21/58, H01L 21/00

(54) **Verfahren und Einrichtung zur Montage von Halbleiterchips auf einem flexiblen Substrat**

(71) Anmelder: Esec Trading S.A., 6330 Cham (CH)
(72) Erfinder: Ulrich, René Josef, 6353 Weggis (CH)
(74) Vertreter: Falk, Urs, Dr.

(57) **Zusammenfassung**

Die Montage von Halbleiterchips (1) auf einem flexiblen Substrat (2) erfolgt in drei Schritten: Zunächst wird an einer Dispensstation (3) Klebstoff (4) auf vorbestimmte Substratplätze (5) auf dem Substrat (2) aufgetragen. Dann werden Halbleiterchips (1) an einer Bondstation (6) auf den Substratplätzen (5) plaziert. Anschliessend erfolgt die Aushärtung des Klebstoffs (4). Erfindungsgemäss wird das Substrat (2) während des Aushärtens des Klebstoffs (4) mittels Vakuum auf einer ebenen Auflagefläche (10) fixiert.

## Beschreibung

Die Erfindung betrifft ein Verfahren und eine Einrichtung zur Montage von Halbleiterchips auf einem flexiblen Substrat.

In der Halbleiterindustrie werden neben den bewährten metallischen Substraten zunehmend flexible Substrate wie z.B. BGA® Flextapes verwendet. Solche Flextapes werden zudem immer dünner und erreichen Dicken von nur noch 50µm. Dies führt zu Schwierigkeiten bei der Montage der Halbleiterchips, die sich in ungleichmässiger Dicke des Klebstoffes zwischen dem Halbleiterchip und dem Flextape, einer Schieflage (tilt) und Fehllagen des Halbeiterchips äussern. Zudem kommt es vor, dass Klebstoff vor dem definitiven Aushärten umherfliesst, sich zusammenzieht, lokal in verschiedene Phasen separiert, etc., was die Qualität der Klebeverbindung stark beeinträchtigen kann. Auch Verunreinigungen der Anschlusspads kann dies zur Folge haben.

Der Erfindung liegt die Aufgabe zugrunde, ein Verfahren und eine Einrichtung anzugeben, mit der flexibe Substrate in zuverlässiger und hoher Qualität mit Halbleiterchips bestückt werden können.

Die Erfindung ist im Anspruch 1 gekennzeichnet. Weiterbildungen der Erfindung ergeben sich aus den abhängigen Ansprüchen.

Die Lösung der Aufgabe gelingt erfindungsgemäss dadurch, dass das Substrat mindestens während des Aushärtens des Klebstoffs, vorzugsweise jedoch während allen kritischen Phasen des Montageprozesses plan auf einer ebenen Auflagefläche gehalten wird.

Bei einer ersten Lösung ist der Montageautomat, ein sogenannter Die Bonder, mit einer Heizplatte ausgerüstet, um den Klebstoff unmittelbar nach der Bestückung mit dem Halbleiterchip auszuhärten. Die Heizplatte weist an ihrer dem Substrat zugewandten Auflagefläche mit Vakuum beaufschlagbare Kanäle oder Ritzen auf, um das Substrat planar zu halten, bis der Klebstoff ausgehärtet ist. Zudem ist der Montageautomat vorzugsweise mit einer Auflageplatte ausgerüstet, die ebenfalls mit Vakuum beaufschlagbare Kanäle oder Ritzen aufweist, um das Substrat während des Auftragens des Klebstoffes und während des Bestückens mit den Halbleiterchips vollflächig an eine ebene Auflagefläche anzusaugen.

Diese Lösung eignet sich insbesondere für die Verarbeitung sogenannter Matrix-Substrate, bei denen die Substratplätze für die Halbleiterchips in Blöcken ä n Reihen und m Kolonnen nebeneinander auf dem Substrat angeordnet sind. Die Montage der Halbleiterchips erfolgt wie üblich in drei Schritten: Im ersten Schritt wird an einer Dispensstation Klebstoff auf die Substratplätze aufgetragen. Im zweiten Schritt werden die Halbleiterchips an einer Bondstation auf den Substratplätzen plaziert. Im dritten Schritt wird der Klebstoff ausgehärtet. Damit für die Aushärtung des Klebstoffs genügend Zeit zur Verfügung steht, erfolgt die Verarbeitung eines solchen Matrix-Substrates blockweise wie folgt: Sobald ein Block mit seinen n x m Substratplätzen vollständig mit Halbleiterchips bestückt ist, wird das Vakuum gelöst und das Substrat in Transportrichtung vorgeschoben. Gleichzeitig werden die Auflageplatte und die Heizplatte entgegen der Transportrichtung zurück in eine vorbestimmte Ausgangsposition verschoben. Danach werden die Kanäle der Auflageplatte als auch der Heizplatte mit Vakuum beaufschlagt, so dass das Substrat an der Auflageplatte und auch an der Heizplatte plan aufliegt und fixiert ist. Anschliessend werden an der Dispensstation die nächsten n x m Substratplätze mit Klebstoff versehen und an der Bondstation die bereits mit Klebstoff versehenen Substratplätze Kolonne um Kolonne mit Halbleiterchips bestückt. Ist eine Kolonne fertig bestückt, dann werden für die Bestückung der nächsten Kolonne die Auflageplatte und die Heizplatte miteinander in Transportrichtung ohne Lösen des Vakuums vorgeschoben. Das Substrat bleibt somit an der Auflageplatte und an der Heizplatte fixiert und wird mitverschoben. Nach der Bestückung der letzten Kolonne eines Blocks beginnt der nächste Zyklus in der beschriebenen Weise mit dem Lösen des Vakkums, dem Vorschub des Substrats und dem Rücktransport der Auflageplatte und der Heizplatte.

Eine Verdoppelung oder Verdreifachung der Aushärtezeit kann erreicht werden, indem die Heizplatte mit zwei bzw. drei Heizpositionen ausgebildet wird. Damit die Durchsatzrate des Montageautomaten relativ hoch gehalten werden kann, müssen bei dieser Lösung relativ schnell aushärtende Klebstoffe verwendet werden.

Bei gewissen Anwendungen genügt es, wenn der Klebstoff nur teilweise, z.B. nur zu 80% ausgehärtet wird. Die restliche Aushärtung erfolgt dann bei einem nachfolgenden Prozesschritt, beispielsweise beim Verdrahten auf einem Wire Bonder.

Bei einer zweiten Lösung erfolgt das Aushärten des Klebstoffs nicht auf dem Montageautomaten, sondern in einem Ofen. Während des Aufenthalts im Ofen wird sichergestellt, dass das Substrat plan auf einer Auflage aufliegt. Als Auflage dient eine Platte, die mit Vakuum beaufschlagbare Kanäle oder Ritzen aufweist, so dass das Substrat angesaugt werden kann. Die Platte kann, muss aber nicht selbst beheizbar sein. Bei dieser Lösung können auch langsam aushärtende Klebstoffe benutzt werden.

Die Erfindung ergibt eine starke Verbesserung der Montagequalität. Da das Substrat während des Aushärtens des Klebstoffes plan gehalten wird, bildet sich zwischen dem Substrat und dem Halbleiterchip eine Klebstoffschicht mit konstanter Dicke: Der Klebstoff vermag das Substrat beim Aushärten nicht mehr zu verbiegen. Zudem ergibt sich eine grössere Homogenität des Klebstoffes, während bei herkömmlicher Aushärtung die verschiedenen Komponenten des Klebstoffs segregieren können, z.B. in silberreiche und silberarme Gebiete, oder auch Leerstellen entstehen können.

Zudem gewährleistet die plane Auflage des Substrats auf der Heizplatte eine zuverlässige Wärmeübertragung von der Heizplatte auf den Klebstoff. Dies ist von grosser Bedeutung, da die Qualität der Wärmeübertragung entscheidenden Einfluss auf die zum vollständigen Aushärten des Klebstoffs erforderliche Aushärtezeit hat.

Nachfolgend werden Ausführungsbeispiele der Erfindung anhand der Zeichnung näher erläutert.

Es zeigen:
- Fig. 1: eine Einrichtung zur Montage von Halbleiterchips,
- Fig. 2: eine Auflageplatte und eine Heizplatte,
- Fig. 3: ein Substrat, und
- Fig. 4 und 5: einen Ofen.

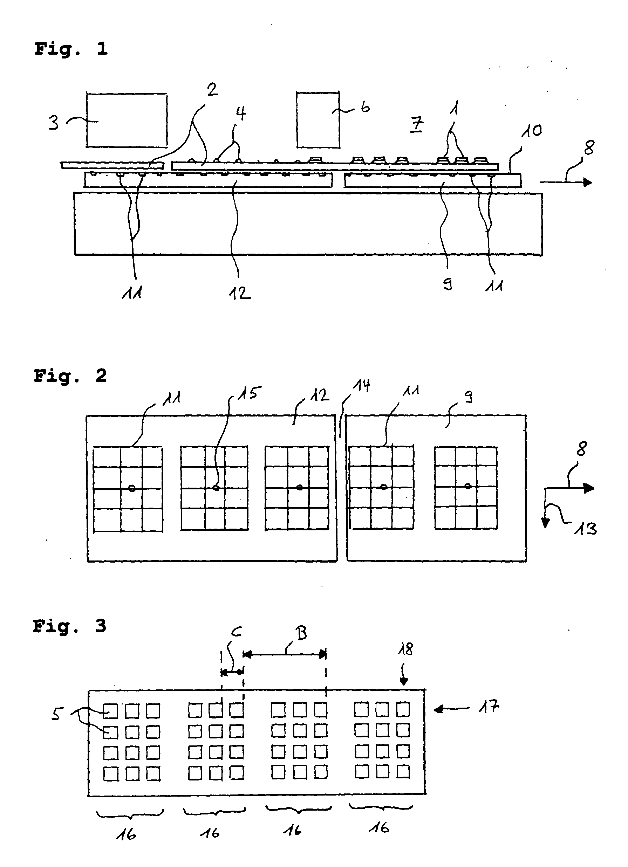

Die Fig. 1 zeigt in schematischer Darstellung eine Einrichtung zur Montage von Halbleiterchips 1 auf einem flexiblen Substrat 2. Die Einrichtung weist eine Dispensstation 3 zum Auftragen von Klebstoff 4 auf Substratplätze 5 (Fig. 3) des Substrats 2, eine Bondstation 6 zum Bestücken der Substratplätze 5 mit den Halbleiterchips 1 und eine Aushärtestation 7 zum Aushärten des Klebstoffes 4 auf, die in Transportrichtung 8 des Substrats 2 nacheinander angeordnet sind. Die Aushärtestation 7 umfasst eine verschiebbare Heizplatte 9, deren dem Substrat 2 zugewandte Auflagefläche 10 mit Vakuum beaufschlagbare Kanäle 11 zum Ansaugen des Substrats 2 aufweist. Die Montageeinrichtung umfasst weiter eine zusammen mit der Heizplatte 9 verschiebbare Auflageplatte 12, die ebenfalls mit Vakuum beaufschlagbare Kanäle 11 zum Ansaugen des Substrats 2 aufweist. Für die Verschiebung der Heizplatte 9 und der Auflageplatte 12 in Transportrichtung 8 und in einer Richtung 13 (Fig. 2) quer zur Transportrichtung 8 sind zwei Antriebe vorhanden.

Die Fig. 2 zeigt in der Aufsicht die Auflageplatte 12 und die Heizplatte 9. Die Auflageplatte 12 und die Heizplatte 9 sind mechanisch miteinander starr verbunden, aber durch einen Spalt 14 getrennt. Damit wird vermieden, dass nennenswerte Wärme von der Heizplatte 9 auf die Auflageplatte 12 übertragen wird, so dass das Aushärten des Klebstoffes 4 erst dann beginnt, wenn sich die Substratplätze 5 auf der Heizplatte 9 befinden. Die Kanäle 11 sind über Bohrungen 15 mit einer Vakuumquelle verbunden. Lage und Länge der einzelnen Kanäle 11 sind so gewählt, dass das Substrat 2 vollflächig angesaugt werden kann, damit es völlig plan auf der Auflageplatte 12 bzw. der Heizplatte 9 anliegt. Die Heizplatte 9 weist zwei Felder mit Kanälen 1 1 auf, damit der Klebstoff 4 während zwei Taktzeiten ausgehärtet werden kann.

Die Fig. 3 zeigt das Substrat 2 in der Aufsicht. Die Substratplätze 5 sind in Blöcken 16 in m Reihen 17 und n Kolonnen 18 angeordnet. Im gezeigten Beispiel ist m=3 und n=4. Die Schrittweite von Kolonne 18 zu Kolonne 18 ist mit C bezeichnet, die Schrittweite von Block 16 zu Block 16 mit B.

Im Produktionsbetrieb der Montageeinrichtung werden die Substratplätze 5 blockweise abgearbeitet: Bei der Dispensstation 3 wird Klebstoff 4 auf die Substratplätze 5 eines ersten Blocks 16 aufgetragen. Bei der Bondstation 6 werden die Halbleiterchips 1 auf den Substratplätzen 5 eines zweiten Blocks 16 plaziert. In der Aushärtestation 7 erfolgt die Aushärtung des Klebstoffs 4 der Substratplätze 5 eines dritten und vierten Blocks 16. Die vier Blöcke 16 gehören entsprechend der Momentaufnahme zum gleichen Substrat 2 oder zu verschiedenen Substraten 2. Die blockweise Abarbeitung bedeutet, dass das Substrat 2 während der Abarbeitung der m ∗ n Substratplätze 5 eines Blocks 16 durchgehend an der Auflageplatte 12 und an der Heizplatte 9 fixiert bleibt. Erst dann, wenn ein Block 16 mit seinen n ∗ m Substratplätzen 5 vollständig mit Halbleiterchips 1 bestückt ist, wird das Vakuum gelöst und das Substrat 2 in Transportrichtung 8 um die Distanz B - (n-1) ∗ C vorgeschoben. Gleichzeitig werden die Auflageplatte 12 und die Heizplatte 9 entgegen der Transportrichtung 8 um die Distanz (n-1) ∗ C zurück in eine vorbestimmte Ausgangsposition verschoben. Danach werden die Kanäle 1 der Auflageplatte 12 als auch der Heizplatte 9 mit Vakuum beaufschlagt, so dass das Substrat 2 an der Auflageplatte 12 und auch an der Heizplatte 9 plan aufliegt und fixiert ist. Anschliessend werden an der Dispensstation 3 die Substratplätze 5 des nächsten Blocks 16 mit Klebstoff 4 versehen und an der Bondstation 6 die bereits mit Klebstoff 4 versehenen Substratplätze 5 Kolonne 18 um Kolonne 18 mit Halbleiterchips 1 bestückt. Ist eine Kolonne 18 fertig bestückt, dann werden für die Bestückung der nächsten Kolonne 18 die Auflageplatte 12 und die Heizplatte 9 miteinander in Transportrichtung 8 ohne Lösen des Vakuums um die Distanz C vorgeschoben. Das Substrat 2 bleibt dabei an der Auflageplatte 12 und an der Heizplatte 9 fixiert und wird mitverschoben. Nach der Bestückung der letzten Kolonne 18 eines Blocks 16 beginnt der nächste Takt in der beschriebenen Weise mit dem Lösen des Vakkums, dem Vorschub des Substrats 2 um die Distanz B - (n-1) ∗ C und dem Rücktransport der Auflageplatte 12 und der Heizplatte 9 um die Distanz (n-1) ∗ C.

Sofern die Bondstation 6 die Halbleiterchips 1 immer an einem vorgegebenen Ort absetzt, werden die Auflageplatte 12 und die Heizplatte 9 für die Bestückung der m innerhalb einer Kolonne 18 liegenden Substratplätze 5 jeweils in der Richtung 13, d.h. orthogonal zur Transportrichtung 8 verschoben.

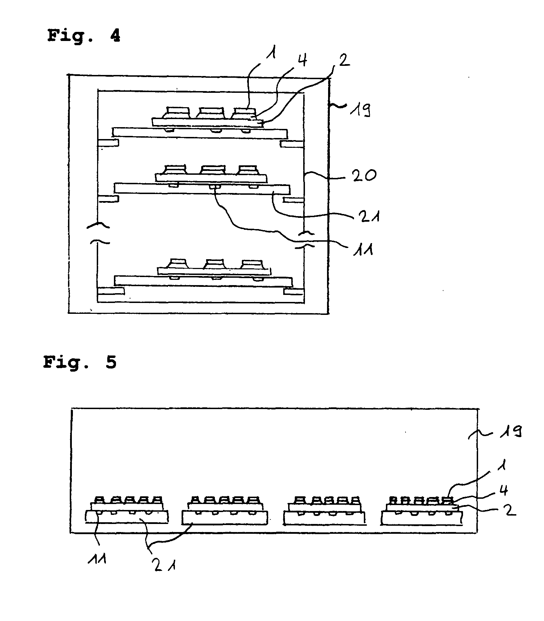

Die Fig. 4 zeigt im Querschnitt einen Ofen 19 für die Aushärtung des Klebstoffes 4. Der Ofen 19 weist ein herausnehmbares Magazin 20 mit einer Vielzahl von Platten 21 mit Kanälen 11 auf, die mit Vakuum zum Ansaugen der Substrate 2 beaufschlagbar sind. Das Magazin 20 wird ausserhalb des Ofens 19 in relativ kaltem Zustand mit den Substraten 2 beladen und die Kanäle 11 von dessen Platten 21 mit Vakuum beaufschlagt, so dass die Substrate 2 vor dem Beginn des Aushärtens flach auf den Platten 21 aufliegen.

Die Fig. 5 zeigt im Querschnitt einen weiteren Ofen 19. der als Durchlaufofen ausgebildet ist. Die mit den Halbleiterchips 1 bestückten Substrate 2 werden nacheinander in Durchlaufrichtung durch den Ofen 19 transportiert. Die Substrate 2 liegen auf Platten 21 auf, die mit Vakuum beaufschlagbare Kanäle 11 zum Ansaugen der Substrate 2 aufweisen, damit diese plan auf den Platten 21 aufliegen.

## Patentansprüche

1. Verfahren zur Montage von Halbleiterchips (1) auf einem flexiblen Substrat (2), wobei an einer Dispensstation (3) Klebstoff (4) auf vorbestimmte Substratplätze (5) auf dem Substrat (2) aufgetragen, an einer Bondstation (6) die Halbleiterchips (1) auf den Substratplätzen (5) plaziert und in einer Aushärtestation (7) der Klebstoff (4) ausgehärtet wird, **dadurch gekennzeichnet, dass** das Substrat (2) während des Aushärtens des Klebstoffs (4) mittels Vakuum auf einer ebenen Auflagefläche (10) fixiert wird.

2. Verfahren nach Anspruch 1, **dadurch gekennzeichnet, dass** das Aushärten des Klebstoffes (4) auf einer der Bondstation (6) unmittelbar nachgelagerten Heizplatte (9) erfolgt, die mit Vakuum beaufschlagbare Kanäle (11) zum Ansaugen des Substrats (2) aufweist.

3. Verfahren nach Anspruch 1, **dadurch gekennzeichnet, dass** das Aushärten des Klebstoffes (4) in einem von der Bondstation (6) getrennten Ofen (19) erfolgt.

4. Verfahren nach Anspruch 1 oder 2 zur Bestückung eines Substrats (2), das in Blöcken (16) angeordnete Substratplätze (5) aufweist, **dadurch gekennzeichnet, dass** das Substrat (2) während der ganzen Dauer des Bestückens eines Blockes (16) mittels Vakuum auf der Heizplatte (9) fixiert ist.

5. Einrichtung zur Montage von Halbleiterchips (1) auf einem flexiblen Substrat (2), mit einer Dispensstation (3) zum Auftragen von Klebstoff (4) auf das Substrat (2) und einer Bondstation (6) zum Bestücken des Substrats (2) mit den Halbleiterchips (1), **dadurch gekennzeichnet, dass** in Transportrichtung (8) des Substrats (2) nach der Bondstation (6) eine Heizplatte (9) angeordnet ist, die mit Vakuum beaufschlagbare Kanäle (11) zum Ansaugen des Substrats (2) aufweist.

6. Einrichtung nach Anspruch 5, **dadurch gekennzeichnet, dass** eine Auflageplatte (12) für das Substrat (2) vorhanden ist, die mit Vakuum beaufschlagbare Kanäle (11) zum Ansaugen des Substrats (2) aufweist, um das Substrat (2) während des Auftragens des Klebstoffes (4) und während des Plazierens des Halbleiterchips (1) planar ausgerichtet zu fixieren, und dass die Auflageplatte (12) und die Heizplatte (9) zusammen in Transportrichtung (8) und quer zur Transportrichtung (8) verschiebbar sind.
